# EUROPÄISCHE PATENTSCHRIFT

(11) **EP 3 796 415 B1**
(45) Veröffentlichungstag und Bekanntmachung des Hinweises auf die Patenterteilung: **08.01.2025**
(21) Anmeldenummer: 20186301.6
(22) Anmeldetag: 16.07.2020
(51) Int. Cl.: H01M 10/60, H01M 10/42, H01M 10/613, H01M 10/655, B60L 58/26, B60L 50/64

(54) **BATTERIE UND VERWENDUNG EINER SOLCHEN BATTERIE**
BATTERY AND USE OF SUCH A BATTERY
BATTERIE ET UTILISATION D'UNE TELLE BATTERIE

(30) Priorität: 18.09.2019 DE 102019214199
(43) Veröffentlichungstag der Anmeldung: 24.03.2021
(73) Patentinhaber: Robert Bosch GmbH, 70442 Stuttgart (DE)
(72) Erfinder: SCHMITT, Markus, 71732 Tamm (DE); KOPP, Benjamin, 71686 Remseck Am Neckar (DE)

(56) Entgegenhaltungen:
- EP-A1- 2 908 377
- EP-A1- 3 331 055
- DE-A1- 102012 012 663
- DE-A1- 102014 007 638
- DE-B4- 102009 056 607
- US-A1- 2015 037 649

## Beschreibung

### Stand der Technik

Die Erfindung geht aus von einer Batterie nach Gattung des unabhängigen Anspruchs. Gegenstand der vorliegenden Erfindung ist auch die Verwendung einer solchen Batterie.

Aus dem Stand der Technik ist es bekannt, dass ein Batteriemodul eine Mehrzahl an einzelnen Batteriezellen aufweist, welche jeweils einen positiven Spannungsabgriff und einen negativen Spannungsabgriff aufweisen, wobei zu einer elektrisch leitenden seriellen und/oder parallelen Verbindung der Mehrzahl an Batteriezellen untereinander die jeweiligen Spannungsabgriffe elektrisch leitend miteinander verbunden sind und somit zu dem Batteriemodul zusammengeschaltet werden können. Batteriemodule ihrerseits werden zu Batterien bzw. zu Batteriesystemen zusammengeschaltet. Aufgrund einer Vielzahl an möglichen, verschiedenen Fahrzeugbauräumen sind variable Modulgrößen anzustreben, um den vorhandenen Bauraum optimal ausnutzen zu können.

Weiterhin erwärmen sich die Batteriezellen eines Batteriemoduls, wie beispielsweise Lithium-Ionen-Batteriezellen oder Lithium-Polymer-Batteriezellen, während eines Betriebes bedingt durch chemische Wandlungsprozesse aufgrund ihres elektrischen Widerstandes bei einer Leistungsabgabe oder einer Leistungsaufnahme. Insbesondere bei einer vergleichbar schnellen Energieabgabe bzw. Energieaufnahme sind diese Prozesse vergleichbar ausgeprägt. Je leistungsfähiger eine Batterie bzw. ein Batteriemodul ist, desto ausgeprägter ist auch die entstehende Erwärmung und damit einhergehend die Anforderungen an ein effizientes Temperiersystem. Um die Sicherheit eines Batteriemoduls zu erhöhen und auch die Leistungsfähigkeit der Batteriezellen sicherzustellen, sind die Batteriezellen eines Batteriemoduls sowohl zu heizen als auch zu kühlen, um diese möglichst in einem bestimmten Temperaturbereich betreiben zu können, sodass beispielsweise ein erhöhtes Alterungsverhalten bzw. eine Zersetzung der Zellchemie verhindert werden kann. Überwiegend sind die Batteriezellen jedoch zu kühlen.

Beispielsweise kann eine Temperierung, also eine Heizung oder Entwärmung, der Batterie durch eine Flüssigkeitstemperierung mit einem Wasser/Glykol-Gemisch ausgebildet werden. Dabei wird dieses Gemisch durch unterhalb des Batteriemoduls angeordnete Kühlplatten geleitet. Die Kühlplatte kann dabei an eine entsprechende Komponente eines Kühlkreislaufes angeschlossen sein. DE102012012663A1 offenbart eine Batterie mit erstem und zweitem Gehäuseelement, wobei das zweite Gehäuseelement auf einer dem Innenraum zugewandten Seite eine Temperierstruktur bildet. DE102014007638A1 offenbart ein Gehäuse mit einer elektrischen Energiespeichereinheit, wobei in die Deckfläche des Gehäuses ein Temperierelement integriert ist. EP3331055A1 offenbart ein Batteriemodul für Fahrzeuge mit Submodulen mit zweiteiligem Gehäuse, wobei in die Bodenplatte des Gehäuses Kühlkanäle integriert sein können, sodass die Bodenplatte eine erste Temperierstruktur enthält, welche die Batterien des Submoduls kühlt. EP2908377A1 offenbart ein Batteriegehäuse mit oberem und unterem Gehäuseteil mit darin einem Batteriemodul, bei welchem angrenzend an die Gehäusebodenplatte eine erste Wärmeaustauscherplatte in den Gehäuseboden integriert ist. DE102009056607A1 offenbart eine Batterie mit einem ersten Gehäuseelement, welches auf der dem Innenraum abgewandten Seite eine Temperierstruktur ausbildet. Ein Zellverbinder ist im Innenraum angeordnet.

### Offenbarung der Erfindung

Die erfindungsgemäße Batterie mit den Merkmalen des unabhängigen Anspruchs bietet den Vorteil, dass eine Temperierung von einzelnen Komponenten der Batterie auf deren jeweilige Bedürfnisse abgestimmt werden kann. Insbesondere durch eine Ausbildung von zwei Temperierfluidaufnahmen als Temperierräumen können die Anforderungen an die Temperierung von einer Mehrzahl an Batteriezellen und von Komponenten der Leistungselektronik getrennt voneinander abgestimmt und optimiert werden. Somit ist eine Optimierung der Temperierung bzw. Entwärmung der Mehrzahl an Batteriezellen getrennt von einer Optimierung der Temperierung bzw. Entwärmung der Komponenten der Leistungselektronik möglich.

Dazu wird erfindungsgemäß eine Batterie gemäß Anspruch 1 zur Verfügung gestellt. Die Batterie umfasst ein erstes Gehäuseelement und ein zweites Gehäuseelement. Das erste Gehäuseelement und das zweite Gehäuseelement bilden gemeinsam einen Innenraum zur Aufnahme eines Batteriemoduls aus. Dabei ist in dem Innenraum eine Mehrzahl an Batteriezellen des Batteriemoduls angeordnet. Die Mehrzahl an Batteriezellen ist elektrisch leitend seriell und/oder parallel miteinander verschaltet. Insbesondere sind die Batteriezellen dabei prismatisch ausgebildet. Bevorzugt ist die Mehrzahl an Batteriezellen als Lithium-lonen-Batteriezellen ausgebildet.

In dem Innenraum ist weiterhin ein erstes Element einer Batteriesteuerung angeordnet.

Das erste Gehäuseelement bildet auf einer dem Innenraum abgewandten Seite eine erste Temperierstruktur aus. Insbesondere ist die erste Temperierstruktur weiterhin auf einer dem zweiten Gehäuseelement abgewandten Seite ausgebildet.

Das zweite Gehäuseelement bildet auf einer dem Innenraum zugewandten Seite eine zweite Temperierstruktur aus. Insbesondere ist die zweite Temperierstruktur weiterhin auf einer dem ersten Gehäuseelement zugewandten Seite ausgebildet. Ein Abdeckelement ist dabei in der Art mit dem zweiten Gehäuseelement verbunden, dass das Abdeckelement eine von Temperierfluid durchströmbare Temperierfluidaufnahme fluiddicht gegenüber dem Innenraum begrenzt. Die zweite Temperierstruktur ist dabei von dem Temperierfluid umströmbar ausgebildet. Durch die in den abhängigen Ansprüchen aufgeführten Maßnahmen sind vorteilhafte Weiterbildungen und Verbesserungen der im unabhängigen Anspruch angegebenen Vorrichtung möglich.

Insbesondere bietet eine erfindungsgemäße Ausführungsform der Batterie den Vorteil, dass eine effiziente Kühlung der einzelnen Komponenten, wie bspw. der Mehrzahl an Batteriezellen sowie den Komponenten der Leistungselektronik, möglich ist, da vergleichbar kurze thermische Pfade ausgebildet sind. Zugleich kann eine kompakte Ausbildung der Batterie zur Verfügung gestellt werden.

Erfindungsgemäß ist das erste Element der Batteriesteuerung thermisch leitend an einer dem Innenraum zugewandten Seite des Abdeckelements angeordnet ist. Dadurch kann das erste Element der Batteriesteuerung zuverlässig temperiert werden. Insbesondere kann das erste Element der Batteriesteuerung dabei unabhängig von der Mehrzahl an Batteriezellen temperiert werden. Die Temperierung des ersten Elements der Batteriesteuerung kann hierbei mittels der Ausbildung der zweiten Temperierstruktur beeinflusst werden.

Es ist weiterhin zweckmäßig, wenn ein zweites Element der Batteriesteuerung thermisch leitend an einer dem Innenraum und insbesondere dem ersten Gehäuseelement abgewandten Seite des zweiten Gehäuseelements angeordnet ist. Dadurch kann das zweite Element der Batteriesteuerung ebenfalls zuverlässig temperiert werden. Insbesondere kann das zweite Element der Batteriesteuerung unabhängig von der Mehrzahl an Batteriezellen temperiert werden.

Erfindungsgemäß umfasst das erste Element der Batteriesteuerung zumindest ein elektronisches Bauteil des Batteriemoduls.

Von Vorteil ist es dabei, wenn ein elektrische Bauteil des Batteriemoduls ein Zellverbinder und/oder eine Leitung ist. Zellverbinder sind hierbei dazu ausgebildet, Spannungsabgriffe der Mehrzahl an Batteriezellen elektrisch leitend seriell und/oder parallel miteinander zu verbinden. Leitungen sind dazu ausgebildet, elektrischen Strom von einem Bauteil zu einem anderen Bauteil zu leiten. Erfindungsgemäß ist das elektronische Bauteil des Batteriemoduls ein Schalter, ein Sicherungselement, ein Batteriesteuerungssystem und/oder ein Widerstand.

Durch die Anordnung des elektrischen Bauteils und des elektronischen Bauteils innerhalb des Innenraums der Batterie ist es möglich, die Mehrzahl an Batteriezellen des Batteriemoduls elektrisch leitend seriell und/oder parallel miteinander zu verschalten sowie das Batteriemodul zu steuern und zu regeln. Weiterhin können diese Komponenten zugleich zuverlässig temperiert werden.

Gemäß einem bevorzugten Aspekt der Erfindung ist das zumindest eine elektronische Bauteil dabei in eine Leiterplatte integriert. Weiterhin kann auch die Leitung zumindest teilweise in die Leiterplatte integriert sein. Dies bietet den Vorteil einer vergleichbar kompakten Ausbildung, welche weiterhin ebenfalls einfach zu temperieren ist.

Es ist ferner zweckmäßig, wenn das zweite Element der Batteriesteuerung ein elektrischer Spannungswandler, insbesondere ein Gleichspannungswandler, ist. Weiterhin der elektrische Spannungswandler bzw. der Gleichspannungswandler auf einer weiteren Leiterplatte angeordnet sein bzw. in eine weitere Leiterplatte integriert sein.

Hierbei kann zwischen dem elektrischen Spannungswandler bzw. dem Gleichspannungswandler und dem zweiten Gehäuseelement weiterhin ein thermisches Ausgleichsmaterial, wie beispielsweise ein thermisch leitfähiger Klebstoff, ein sogenannter Gapfiller oder ein sogenanntes thermal interface material (TIM), angeordnet sein. Durch eine Verbindung, wie beispielsweise mittels Schrauben, des elektrischen Spannungswandlers mit dem zweiten Gehäuseelement kann eine zuverlässige, thermische Leitung ausgebildet werden. Insgesamt ergibt sich hierdurch ein vergleichbar kurzer thermischer Pfad zwischen einem die Temperfluidaufnahme des zweiten Gehäuseelements durchströmenden Temperierfluid und dem elektrischen Spannungswandler bzw. dem Gleichspannungswandler mit einem somit vergleichbar niedrigen thermischen Widerstand.

Besonders bevorzugt ist es, wenn das Abdeckelement planar und aus einem metallischen Werkstoff ausgebildet ist oder wenn das Abdeckelement eine Umformung zur Aufnahme des ersten Elements der Batteriesteuerung aufweist. Insbesondere kann das Abdeckelement hierbei bevorzugt aus einem metallischen Blech ausgebildet sein.

Das Abdeckelement kann hierbei bspw. stoffschlüssig, wie insbesondere geschweißt, mit dem zweiten Gehäuseelement verbunden sein. Hierzu kann das zweite Gehäuseelement bspw. einen Anbindungsbereich aufweisen, welcher ausgebildet, stoffschlüssig mit dem Abdeckelement verbunden zu sein. An dieser Stelle sei noch einmal angemerkt, dass das Abdeckelement die Temperierfluidaufnahme fluiddicht gegenüber dem Innenraum abdichtet. Insbesondere durch die stoffschlüssige Verbindung des Abdeckelements mit dem Anbindungsbereich des zweiten Gehäuseelements kann eine solche Abdichtung ausgebildet werden.

Weiterhin ist es auch möglich, dass das Abdeckelement beispielsweise formschlüssig, wie insbesondere geschraubt, mit dem zweiten Gehäuseelement verbunden sein kann. Zur zuverlässigeren Abdichtung kann hierbei zwischen dem Abdeckelement und dem zweiten Gehäuseelement weiterhin ein zusätzliches Dichtelement angeordnet sein.

Eine planare Ausbildung des Abdeckelements bietet den Vorteil, dass eine vergleichbar möglichst große thermische Kontaktfläche zur Anbindung des ersten Elements der Batteriesteuerung ausgebildet ist.

Ein Abdeckelement mit einer Umformung zur Aufnahme des ersten Elements der Batteriesteuerung bietet zum Beispiel den Vorteil, dass eine von Temperierfluid durchströmbare Höhe der Temperierfluidaufnahme entsprechend angepasst werden kann, wodurch ein besonders Bauraum optimiertes Design zur Verfügung gestellt werden kann. Des Weiteren kann eine zuverlässige Aufnahme des ersten Elements der Batteriesteuerung durch die Umformung zur Verfügung gestellt werden. An dieser Stelle sei auch noch angemerkt, dass beispielsweise durch die Ausbildung mit einem Biegewinkel eine in Strömungsrichtung oder in Längsrichtung der Temperierfluidaufnahme abnehmende Höhe der Temperierfluidaufnahme ausgebildet werden kann.

Weiterhin sei bemerkt, dass das Abdeckelement aus einem metallischen Werkstoff ausgebildet ist, der metallische Werkstoff kann dabei ausgewählt sein, aus Aluminium, Kupfer oder Nickel. Dies bietet den Vorteil einer vergleichbar hohen thermischen Leitfähigkeit.

Insbesondere kann hierbei zwischen dem ersten Element der Batteriesteuerung und dem Abdeckelement ein thermisches Ausgleichselement, wie beispielsweise ein thermisch leitfähiger Klebstoff, angeordnet sein.

Zweckmäßigerweise ist die Mehrzahl an Batteriezellen thermisch leitend mit einer unmittelbar benachbart zu der ersten Temperierstruktur angeordneten Innenseite des Innenraums angeordnet. Dadurch kann die Mehrzahl an Batteriezellen insgesamt sehr zuverlässig temperiert werden. Zudem kann die Mehrzahl an Batteriezellen dadurch beispielsweise unabhängig von dem ersten Element der Batteriesteuerung sowie auch unabhängig von dem zweiten Element der Batteriesteuerung temperiert werden. Insbesondere kann hierbei zwischen der Mehrzahl an Batteriezellen und der Innenseite ein thermisches Ausgleichselement, wie beispielsweise ein thermisch leitfähiger Klebstoff, angeordnet sein.

Es ist zweckmäßig, wenn das erste Gehäuseelement und/oder das zweite Gehäuseelement jeweils als Druckgussgehäuse ausgebildet sind. Dadurch kann eine mechanisch vergleichbar stabile Ausbildung zur Verfügung gestellt werden. Zudem ist es dadurch möglich, dass Temperfluid führende Bereiche innerhalb der Druckgussbauteile ausgebildet werden können, sodass auf zusätzliche Kühlplatten, Heizelemente oder Temperiersysteme verzichtet werden kann.

Von Vorteil ist es, wenn das erste Gehäuseelement und das zweite Gehäuseelement fluiddicht ausgebildet miteinander verbunden sind. Insbesondere ist hierzu ein Dichtungselement zwischen dem ersten Gehäuseelement und dem zweiten Gehäuseelement angeordnet. Somit kann ein fluiddicht abgeschlossener Innenraum der Batterie zur Verfügung gestellt werden. Insbesondere können hierdurch die Batteriezellen, das elektrische Bauteil und/oder das elektronische Bauteile vor äußeren Einflüssen geschützt werden.

Gemäß einem bevorzugten Aspekt der Erfindung ist die Mehrzahl an Batteriezellen als prismatische Batteriezellen ausgebildet. Prismatische Batteriezellen weisen hierbei insgesamt sechs Seitenflächen auf, welche paarweise einander gegenüberliegend und parallel zueinander angeordnet sind. Weiterhin sind benachbart zueinander angeordnete Seitenflächen rechtwinklig zueinander angeordnet. Insgesamt ist es möglich, durch die Verwendung von prismatischen Batteriezellen in einer erfindungsgemäßen Batterie eine kompakte Batterie zur Verfügung zu stellen.

Zweckmäßig ist es, wenn ein weiteres Abdeckelement an dem ersten Gehäuseelement angeordnet ist. Insbesondere ist das weitere Abdeckelement mit dem ersten Gehäuseelement verbunden angeordnet. Dabei bilden das weitere Abdeckelement und die erste Temperierstruktur gemeinsam eine von Temperierfluid durchströmbar ausgebildete weitere Temperierfluidaufnahme aus. Das weitere Abdeckelement begrenzt dabei die weitere Temperierfluidaufnahme fluiddicht gegenüber einer Umgebung. Zudem ist die erste Temperierstruktur von dem Temperierfluid umströmbar ausgebildet. Dies bietet den Vorteil, dass die erste Temperierstruktur an die Anforderungen hinsichtlich der Temperierung der Mehrzahl an Batteriezellen, welche in dem Innenraum aufgenommen sind, angepasst werden kann. Diese Anpassung kann hierbei unabhängig bspw. von der Kühlung des elektrischen Bauteils und/oder des elektronischen Bauteils sowie unabhängig von der Kühlung des elektrischen Spannungswandlers bzw. des Gleichspannungswandler eingestellt werden. Beispielsweise kann die erste Temperierstruktur Strömungsstörelemente oder Strömungsleitelemente umfassen, welche nur dort angeordnet sind, wo sie aufgrund von geforderten Temperaturen der Mehrzahl an Batteriezellen die Temperierung positiv beeinflussen können. Weiterhin können die übrigen Bereiche der weiteren Temperierfluidaufnahme hinsichtlich der Strömung und des Druckverlustes optimiert werden. Insbesondere kann auf einen Kompromiss zwischen einer Temperierung der Mehrzahl an Batteriezellen und dem elektrischen Bauteil und/oder dem elektronischen Bauteil sowie dem elektrischen Spannungswandler verzichtet werden, da eine voneinander unabhängige Temperierung dieser Komponenten möglich ist.

Bevorzugt ist das weitere Abdeckelement dabei stoffschlüssig mit dem ersten Gehäuseelement verbunden. Insbesondere kann das weitere Abdeckelement geschweißt oder gelötet mit dem ersten Gehäuseelement verbunden sein. Des Weiteren kann zwischen dem ersten Gehäuseelement und dem Abdeckelement ein zweites Dichtungselement angeordnet sein.

Es ist auch bevorzugt möglich, wenn das weitere Abdeckelement durch das erste Gehäuseelement ausgebildet wird.

Insgesamt bietet dies den Vorteil, dass durch eine solche Ausbildung verhindert werden kann, dass bei Fehlern oder undichten Stellen des ersten Temperierraums, Temperierfluid in den Innenraum zu der Mehrzahl an Batteriezellen gelangen kann.

Vorteilhafterweiße umfasst die Batterie einen ersten Anschluss und einen zweiten Anschluss. Der erste Anschluss ist dabei dazu ausgebildet, der Batterie das Temperierfluid zuzuführen und der zweite Anschluss ist dabei dazu ausgebildet, das Temperierfluid von der Batterie abzuführen.

Insbesondere bilden der erste Anschluss und der zweite Anschluss eine Schnittstelle zu einem Kraftfahrzeug.

Gemäß einem ersten Aspekt kann das Temperierfluid die Temperierfluidaufnahme und die weitere Temperierfluidaufnahme seriell durchströmen. Dabei strömt das Temperierfluid beispielsweise zunächst durch die Temperierfluidaufnahme und anschließend durch die weitere Temperierfluidaufnahme oder umgekehrt zunächst durch die weitere Temperierfluidaufnahme und anschließend durch die Temperierfluidaufnahme.

Gemäß zweiten Aspekt der Erfindung kann das Temperierfluid die Temperierfluidaufnahme und die weitere Temperierfluidaufnahme parallel durchströmen. Dabei wird das Temperierfluid nach einem Durchströmen des ersten Anschlusses in einen ersten Teilstrom aufgeteilt, welcher die Temperierfluidaufnahme durchströmt, und in einem zweiten Teilstrom aufgeteilt, welcher die weitere Temperierfluidaufnahme durchströmt. Der erste Teilstrom und der zweite Teilstrom werden nach einem Durchströmen der jeweiligen Temperierfluidaufnahme wieder zusammengeführt und mittels des zweiten Anschlusses aus der Batterie herausgeführt.

Hierdurch kann insgesamt bspw. der Druckverlust minimiert werden. Weiterhin kann hierdurch bspw. auch der Wärmeübergang verbessert werden.

Insbesondere weisen hierbei das erste Gehäuseelement und/oder das zweite Gehäuseelement jeweils einen Temperierfluideinlass und einen Temperierfluidauslass auf. Der jeweilige Temperierfluideinlass dient dazu, Temperierfluid in die Temperierfluidaufnahme bzw. die weitere Temperierfluidaufnahme einzulassen, und der jeweilige Temperierfluidauslass dient dazu, Temperierfluid aus der Temperierfluidaufnahme bzw. der weiteren Temperierfluidaufnahme auszulassen. Weiterhin können ein Temperierfluidauslass und ein Temperierfluideinlass auch fluidleitend miteinander verbunden sein, sodass Temperierfluid zwischen der Temperierfluidaufnahme und der weiteren Temperierfluidaufnahme oder umgekehrt strömen kann.

Beispielsweise kann der Temperierfluideinlass des ersten Gehäuseelements den ersten Anschluss der Batterie ausbilden, sodass Temperierfluid hierdurch einströmen kann. Weiterhin kann beispielsweise der Temperierfluidauslass des ersten Gehäuseelements fluidleitend mit dem Temperierfluideinlass des zweiten Gehäuseelements verbunden sein, sodass Temperierfluid zuerst die weitere Temperierfluidaufnahme und anschließend die Temperierfluidaufnahme durchströmen kann, also eine serielle Durchströmung ausgebildet ist. Zudem kann beispielsweise der Temperierfluidauslass des zweiten Gehäuseelements den zweiten Anschluss der Batterie ausbilden, sodass hierdurch Temperierfluid die Temperierfluidaufnahme verlassen kann.

Beispielsweise kann der Temperierfluideinlass des zweiten Gehäuseelements den ersten Anschluss der Batterie ausbilden, sodass Temperierfluid hierdurch in die Temperierfluidaufnahme einströmen kann. Weiterhin kann beispielsweise der Temperierfluidauslass des zweiten Gehäuseelements fluidleitend mit dem Temperierfluideinlass des ersten Gehäuseelements verbunden sein, sodass Temperierfluid zuerst die Temperierfluidaufnahme und anschließend die weitere Temperierfluidaufnahme durchströmen kann, also eine serielle Durchströmung ausgebildet ist.

An dieser Stelle sei angemerkt, dass eine solche Verbindung zwischen dem Temperierfluideinlass des einen Gehäuseelements und dem Temperierfluidauslass des anderen Gehäuseelements bevorzugt innerhalb des ersten Gehäuseelements und/oder innerhalb des zweiten Gehäuseelements ausgebildet sind, welche weiterhin besonders bevorzugt jeweils als Druckgussgehäuse ausgebildet sind.

Es ist zweckmäßig, wenn die erste Temperierstruktur und/oder die zweite Temperierstruktur jeweils als Strömungsleitelemente, als Strömungsstörelemente oder als Strömungsbegrenzungen ausgebildet sind.

Insbesondere können die erste Temperierstruktur und/oder die zweite Temperierstruktur jeweils durch das entsprechende Druckgussgehäuse ausgebildet werden.

An dieser Stelle sind unter Strömungsleitelementen solche innerhalb eines jeweiligen Temperierraums angeordnete Elemente zu verstehen, welche dazu dienen, eine Strömung ohne eine vergleichbare Erhöhung der Turbulenz umzuleiten.

An dieser Stelle sind unter Strömungsstörelementen solche innerhalb eines jeweiligen Temperierraums angeordnete Elemente zu verstehen, welche dazu dienen, die Turbulenz einer Strömung zu erhöhen, insbesondere einen Übergang von einer laminaren zu einer turbulenten Strömung herbeizuführen, um jedenfalls eine verbesserte Wärmeabfuhr zu bewirken.

An dieser Stelle sind unter Strömungsbegrenzungen solche Elemente zu verstehen, welche den jeweiligen Temperierraum mechanisch begrenzen.

Von Vorteil ist es auch, wenn das elektrische Bauteil und/oder das elektronische Bauteil thermisch leitend mit einer dem Innenraum zugewandten Seite des Abdeckelements verbunden sind. Insbesondere kann hierbei zwischen dem elektrischen Bauteil und/oder dem elektronischen Bauteil sowie dem Abdeckelement ein thermisches Ausgleichselement, wie beispielsweise ein thermisch leitfähiger Klebstoff oder ein sogenanntes thermal interface material (TIM), angeordnet sein. Beispielsweise durch eine Verbindung einer das elektronische Bauteil umfassenden Leiterplatte mit dem Abdeckelement, beispielsweise auch mittels Schrauben oder mittels einer stoffschlüssigen Verbindung, kann eine zuverlässige thermische Leitung ausgebildet werden. Insgesamt ergibt sich hierdurch ein vergleichbar kurzer thermischer Pfad zwischen einem die Temperierfluidaufnahme durchströmenden Temperierfluid und der Leiterplatte mit einem somit vergleichbar niedrigen thermischen Widerstand.

Gegenstand der vorliegenden Erfindung ist auch die Verwendung einer Batterie gemäß Anspruch 1 zur Temperierung und insbesondere zur Kühlung der Mehrzahl an Batteriezellen, des elektrischen Bauteils und des elektronischen Bauteils und des elektrischen Spannungswandlers, wobei ein als Temperierflüssigkeit oder Temperiergas ausgebildetes Temperierfluid die erste Temperierstruktur umströmt oder wobei das als Temperierflüssigkeit ausgebildete Temperierfluid die Temperierfluidaufnahme durchströmt. Insbesondere wird die Batterie dabei in der Art betrieben, dass die Temperatur der Batteriezellen, welche bevorzugt als Lithium-lonen-Batteriezellen ausgebildet sind, unterhalb einer Temperatur von 40 °C und bevorzugt unterhalb einer Temperatur von 35 °C liegt. Dadurch kann eine hinreichende thermische Konditionierung der Batterie ausgebildet werden, wodurch die Batteriezellen in einem thermisch unkritischen Zustand betrieben werden können, sodass bspw. ein Alterungsgleichlauf der Batteriezellen erreicht werden kann, da insbesondere ein Temperaturgradient von Batteriezelle zu Batteriezelle vergleichbar gering ist.

### Kurze Beschreibung der Zeichnungen

Ausführungsbeispiele der Erfindung sind in den Zeichnungen dargestellt und in der nachfolgenden Beschreibung näher erläutert.

Es zeigt:
- Figur 1: in einer perspektivischen Ansicht eine Ausführungsform einer erfindungsgemäßen Batterie,
- Figur 2: in einer Schnittansicht die Ausführungsform einer Batterie gemäß Figur 1,
- Figur 3: in einer perspektivischen Ansicht eine Unterseite eines zweiten Gehäuseelements,
- Figur 4: in einer perspektivischen Ansicht eine Oberseite des zweiten Gehäuseelements gemäß Figur 3,
- Figur 5: in einer perspektivischen Ansicht eine Unterseite eines zweiten Gehäuseelements mit einem Abdeckelement,
- Figur 6: in einer Explosionsdarstellung einen Ausschnitt einer erfindungsgemäßen Batterie,
- Figur 7: in einer perspektivischen Ansicht eine Oberseite eines ersten Gehäuseelements und
- Figur 8: in einer perspektivischen Ansicht eine Unterseite eines ersten Gehäuseelements.

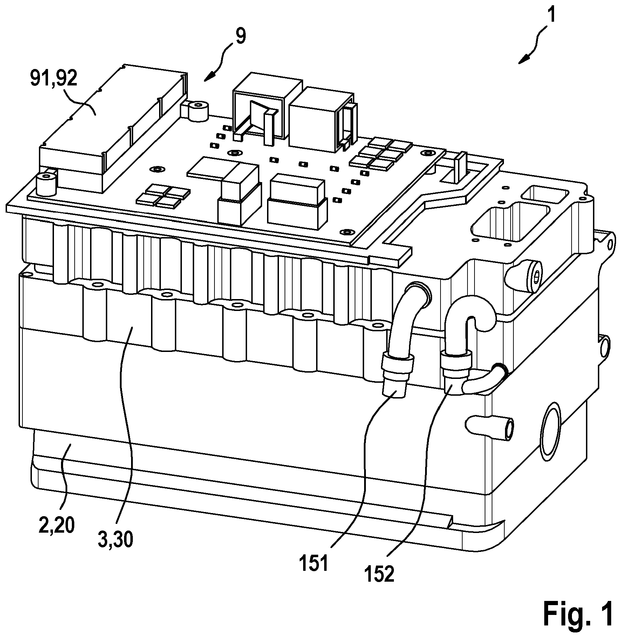

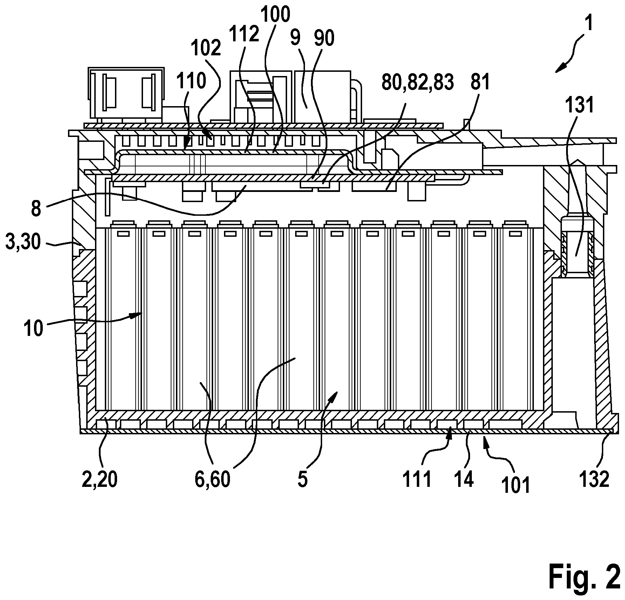

Die Figur 1 zeigt in einer perspektivischen Ansicht eine Ausführungsform einer erfindungsgemäßen Batterie 1. Die Figur 2 zeigt diese erfindungsgemäße Ausführungsform der Batterie 1 gemäß Figur 1 in einer Schnittansicht. Die Figuren 1 und 2 sollen nun gemeinsam beschrieben sein.

Die Batterie 1 umfasst ein erstes Gehäuseelement 2 und ein zweites Gehäuseelement 3. Gemäß der in den Figuren 1 und 2 gezeigten Ausführungsform der Batterie 1 ist das erste Gehäuseelement 2 als Druckgussgehäuse 20 ausgebildet und das zweite Gehäuseelement 3 als Druckgussgehäuse 30 ausgebildet.

Das erste Gehäuseelement 2 und das zweite Gehäuseelement 3 bilden gemeinsam einen Innenraum 5 zur Aufnahme eines Batteriemoduls 10 aus. Insbesondere in der Schnittansicht gemäß Figur 2 sind der Innenraum 5 und das Batteriemodul 10 zu erkennen. Insbesondere sind das erste Gehäuseelement 2 und das zweite Gehäuseelement 3 fluiddicht ausgebildet miteinander verbunden. Dazu ist zwischen dem ersten Gehäuseelement 2 und dem zweiten Gehäuseelement 3 ein Dichtungselement 131 angeordnet. Insbesondere können das erste Gehäuseelement 2 und das zweite Gehäuseelement 3 auch geschraubt miteinander verbunden sein, um eine zuverlässige mechanische Verbindung auszubilden.

In dem Innenraum 5 ist eine Mehrzahl an Batteriezellen 6 aufgenommen. Die Mehrzahl an Batteriezellen 6 des Batteriemoduls 10 ist dabei elektrisch leitend seriell und/oder parallel miteinander verschaltet. Bevorzugt sind, wie bspw. aus der Figur 2 zu erkennen ist, die Mehrzahl an Batteriezellen 6 jeweils als prismatische Batteriezellen 60 ausgebildet.

Das zweite Gehäuseelement 3 bildet auf einer dem Innenraum 5 zugewandten Seite eine zweite Temperierstruktur 102 aus. Insbesondere ist die zweite Temperierstruktur 102 dem ersten Gehäuseelement 2 zugewandt angeordnet.

Weiterhin umfasst die Batterie 1 ein Abdeckelement 100, welches in der Art mit dem zweiten Gehäuseelement 3 verbunden ist, dass das Abdeckelement 100 eine von Temperierfluids durchströmbare Temperierfluidaufnahme 112 fluiddicht gegenüber dem Innenraum 5 begrenzt. Weiterhin ist die zweite Temperierstruktur 102 von dem Temperierfluid umströmbar ausgebildet.

Das Abdeckelement 100 weist dabei gemäß den Ausführungen der Figuren 1 und 2 eine Umformung 110 zur Aufnahme eines ersten Elements 8 der Batteriesteuerung auf. Weiterhin ist es auch möglich, dass das Abdeckelement 100 planar aus einer Metall ausgebildet ist.

Weiterhin ist in dem Innenraum 5 ein erstes Element 8 einer Batteriesteuerung angeordnet. Das erste Element 8 der Batteriesteuerung ist dabei thermisch leitend an einer dem Innenraum 5 zugewandten Seite des Abdeckelement 100 angeordnet.

Das erste Element 8 der Batteriesteuerung umfasst erfindungsgemäß zumindest ein elektronisches Bauteil 81 des Batteriemoduls 10. Elektrische Bauteile 80 des Batteriemoduls 10 können Zellverbinder 82 sein, welche die Mehrzahl an Batteriezellen 6, 60 elektrisch leitend seriell und/oder parallel miteinander verschalten. Weiterhin können die elektrischen Bauteile 8 Leitungen 83 sein, welche elektrischen Strom führen. Erfindungsgemäß sind die elektronischen Bauteile 81 des Batteriemoduls 6 Schalter, Sicherungselemente, Batteriesteuerungssysteme und/oder Widerstände. Besonders bevorzugt sind die elektronischen Bauteile 81, wie aus der Figur 2 zu erkennen ist, zumindest teilweise in eine Leiterplatte 90 integriert.

Das erste Gehäuseelement 2 bildet auf einer dem Innenraum 5 abgewandten Seite eine erste Temperierstruktur 101 aus. Insbesondere bei der Ausführungsform gemäß den Figuren 1 und 2 ist die erste Temperierstruktur 101 auf einer dem zweiten Gehäuseelement 3 abgewandten Seite des ersten Gehäuseelements 2 angeordnet. Weiterhin zeigt die Figur 2 auch, dass ein weiteres Abdeckelement 14 an dem ersten Gehäuseelement 2 angeordnet ist. Dabei bilden das Abdeckelement 14 und das erste Gehäuseelement 2 gemeinsam eine von Temperierfluid durchströmbare weitere Temperierfluidaufnahme 111 aus. Die erste Temperierstruktur 101 ist dabei innerhalb der weiteren Temperierfluidaufnahme 111 angeordnet. Insbesondere kann das Abdeckelement 14 stoffschlüssig mit dem ersten Gehäuseelement 2 verbunden sein. Dabei kann weiterhin bevorzugt ein Dichtungselement 132 zwischen dem ersten Gehäuseelement 2 und dem Abdeckelement 14 angeordnet sein.

Dabei ist wie aus der Figur 2 zu erkennen ist, die Mehrzahl an Batteriezellen 6 thermisch leitend mit einer unmittelbar benachbart zu der ersten Temperierstruktur 101 angeordneten ersten Innenseite des Innenraums 5 angeordnet

Weiterhin zeigt insbesondere die Figur 1, dass die Batterie 1 einen ersten Anschluss 151 und einen zweiten Anschluss 152 aufweist. Der erste Anschluss 151 ist dabei dazu ausgebildet, der Batterie 1 Temperierfluid zuzuführen und der zweite Anschluss 152 ist dabei dazu ausgebildet, Temperierfluid von der Batterie 1 abzuführen. Dabei kann das Temperierfluid die Batterie 1 und insbesondere die weitere Temperierfluidaufnahme 111 und die Temperierfluidaufnahme 112 seriell oder parallel durchströmen.

Weiterhin umfasst das Batteriemodul ein zweites Element 9 der Batteriesteuerung. Das zweite Element 9 der Batteriesteuerung ist dabei thermisch leitend an einer dem Innenraum 5 und insbesondere dem ersten Gehäuseelement 2 abgewandten Seite des zweiten Gehäuseelements 3 angeordnet.

Insbesondere kann das zweite Element 9 der Batteriesteuerung ein elektrischer Spannungswandler 91, wie insbesondere ein Gleichspannungswandler 92, sein.

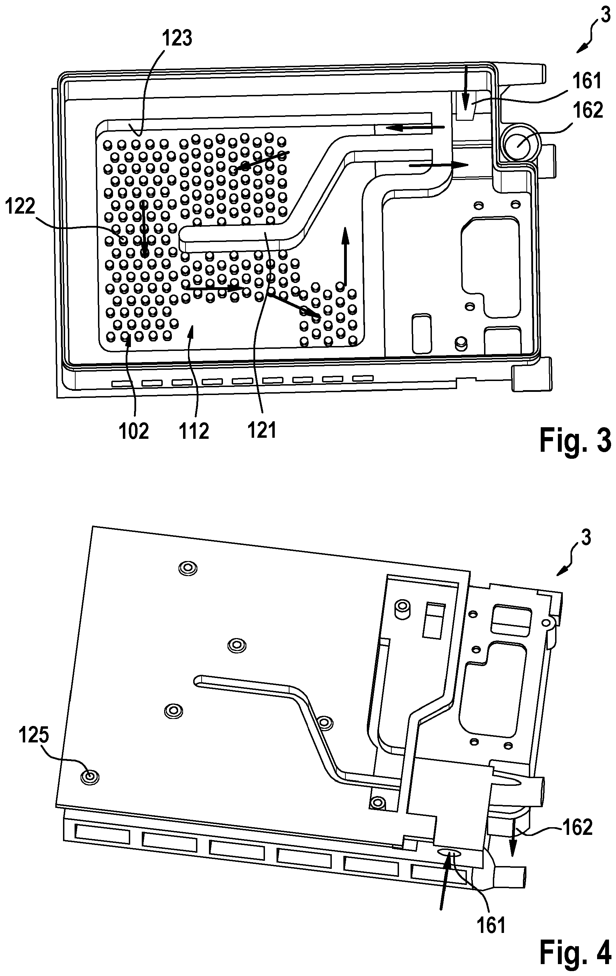

Figur 3 zeigt in einer perspektivischen Ansicht eine Unterseite eines erfindungsgemäßen zweiten Gehäuseelements 3. Dabei ist der Temperierfluideinlass 161 des zweiten Gehäuseelements 3 zu erkennen, welcher ausgebildet ist, Temperierfluid in die Temperierfluidaufnahme 112 einzulassen. Weiterhin ist dabei der Temperierfluidauslass 162 des zweiten Gehäuseelements 3 zu erkennen. Der zweite Temperierfluidauslass 162 dazu ausgebildet, Temperierfluid aus der Temperierfluidaufnahme 112 auszulassen.

An dieser Stelle sei angemerkt, dass der Temperierfluideinlass 161 auch den ersten Anschluss 151 der Batterie 1 ausbilden kann bzw. mit dem ersten Anschluss 151 fluidleitend verbunden sein kann oder dass der Temperierfluidauslass 162 auch den zweiten Anschluss 152 der Batterie 1 ausbilden kann bzw. mit dem zweiten Anschluss 152 fluidleitend verbunden sein kann.

Weiterhin zeigt die Figur 3 auch, dass das zweite Gehäuseelement 3 die zweite Temperierstruktur 102 umfasst. Die zweite Temperierstruktur 102 kann dabei Strömungsleitelemente 121 umfassen, welche ausgebildet sind, die Temperierfluidaufnahme 112 in der Art zu begrenzen, dass das Temperierfluid entsprechend geführt ist. Weiterhin kann die zweite Temperierstruktur 102 dabei Strömungsstörelemente 122 umfassen, welche ausgebildet sind, die Turbulenz des die Temperierfluidaufnahme 112 durchströmenden Temperierfluids zu erhöhen. Ferner kann die zweite Temperierstruktur 102 auch Strömungsbegrenzungen 123 umfassen, welche die Temperierfluidaufnahme 112 fluiddicht begrenzen.

Eine Strömungsführung innerhalb der Temperierfluidaufnahme 112 ist schematisch durch die gezeigten Pfeile dargestellt. Insbesondere ist die Strömungsführung U-förmig ausgebildet.

An dieser Stelle sei bereits angemerkt, dass das Abdeckelement 100 in der Art angeordnet wird, dass die Temperierfluidaufnahme 112 gegenüber dem Innenraum 5 fluiddicht abgeschlossen ist. Insbesondere kann das Abdeckelement 100 dabei beispielsweise stoffschlüssig mit dem zweiten Gehäuseelement 3 verbunden sein.

Die Figur 4 zeigt in einer perspektivischen Ansicht eine Oberseite des zweiten Gehäuseelements 3 gemäß Figur 3. Insbesondere sind auch hierbei der Temperierfluideinlass 161 des zweiten Gehäuseelements 3 sowie der Temperierfluidauslass 162 des zweiten Gehäuseelements 3 gezeigt.

Insbesondere sei in dieser Stelle angemerkt, dass das zweites Element 9 der Batteriesteuerung, beispielsweise der elektrische Spannungswandler 91 bzw. insbesondere der Gleichspannungswandler 92 unmittelbar thermisch leitend an der gezeigten Oberseite angeordnet werden können. Hierzu kann das zweite Gehäuseelement 3 beispielsweise Verschraubungspunkte 125 aufweisen.

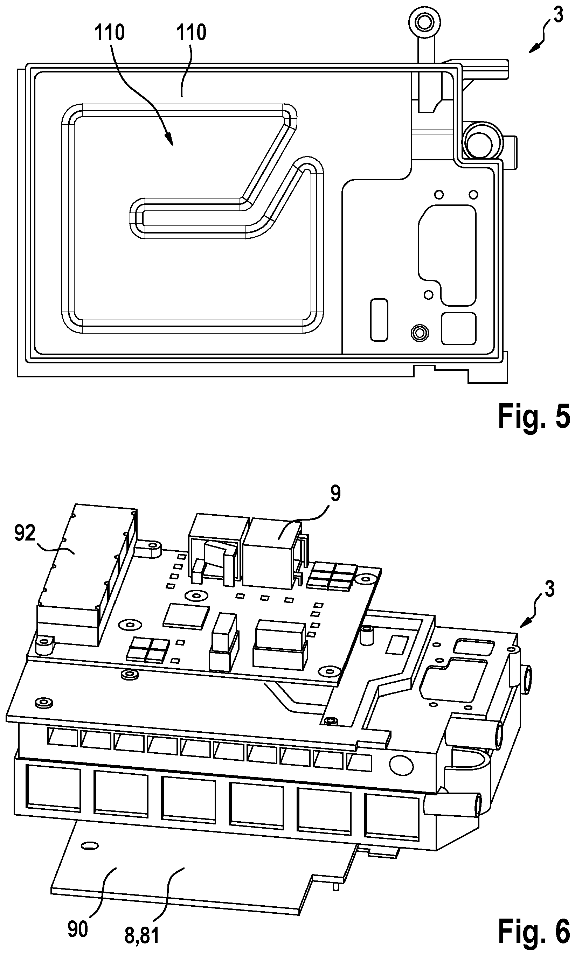

Figur 5 zeigt in einer perspektivischen Ansicht eine Unterseite eines erfindungsgemäßen zweiten Gehäuseelements 3 mit einem Abdeckelement 100. Insbesondere entspricht die Ausführung des zweiten Gehäuseelements 3 der Ausführung gemäß Figur 3. Das Abdeckelement 100 ist hierbei in der Art mit dem zweiten Gehäuseelement 3 verbunden, dass das Abdeckelement 100 die Temperierfluidaufnahme 112 fluiddicht gegenüber dem Innenraum 5 begrenzt. Gemäß der Figur 5 ist das Abdeckelement 100 aus einem metallischen Werkstoff ausgebildet. Weiterhin weist das Abdeckelement 100 eine Umformung 110 auf. Die Umformung 110 ist dabei zur Aufnahme des ersten Elements 8 der Batteriesteuerung ausgebildet, wie beispielsweise auch aus Figur 2 zu erkennen ist.

Die Figur 6 zeigt in einer Explosionsdarstellung einen Ausschnitt einer erfindungsgemäßen Batterie 1.

Dabei ist das zweite Gehäuseelement 3 gezeigt. Weiterhin ist das erste Element 8 der Batteriesteuerung zu erkennen, welches ein elektronisches Bauteil 81 umfasst. Dabei ist das elektronische Bauteil 81 in eine Leiterplatte 90 integriert.

Weiterhin ist zu erkennen, dass das erste Element 8 der Batteriesteuerung an einer dem Innenraum 5 zugewandten Seite des Abdeckelement 100 angeordnet wird.

Ferner zeigt die Figur 6 auch das zweite Element 9 der Batteriesteuerung, welches thermisch leitend an einer dem Innenraum 5 abgewandten Seite des zweiten Gehäuseelements 3 angeordnet ist. Hierbei ist das zweite Element 9 der Batteriesteuerung insbesondere als Gleichspannungswandler 92 ausgebildet. Dabei kann das zweite Element 9 der Batteriesteuerung beispielsweise mittels der in Figur 4 gezeigten Verschraubungspunkte 125 mit dem zweiten Gehäuseelement 3 verbunden sein.

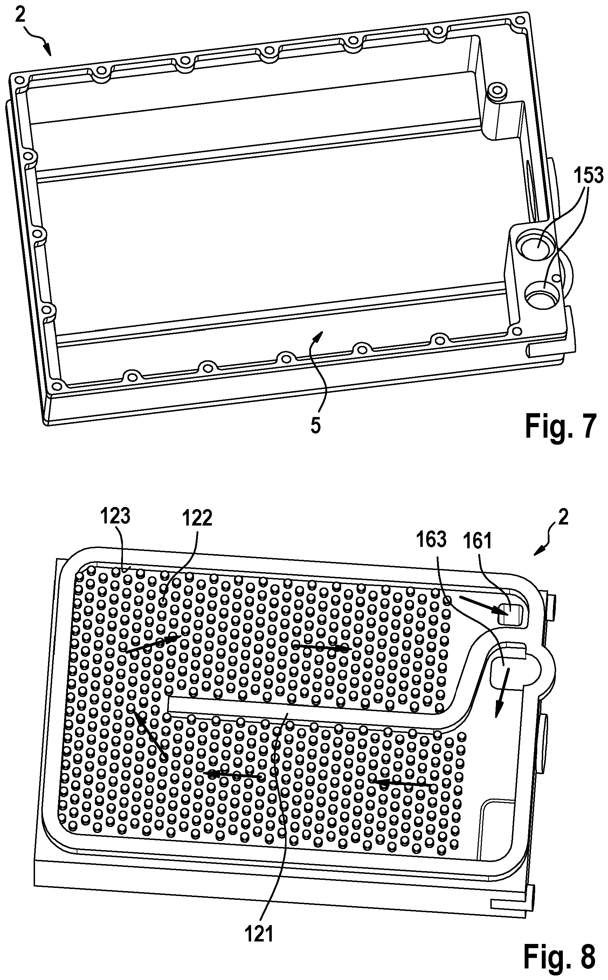

Figur 7 zeigt in einer perspektivischen Ansicht eine Oberseite eines ersten Gehäuseelements 2. Dabei ist insbesondere der Innenraum 5 zu erkennen, welche die Mehrzahl an in der Figur 7 nicht zu erkennenden Batteriezellen 6 aufnimmt. Weiterhin sind Temperierfluidführung 153 gezeigt, die innerhalb des ersten Gehäuseelements 2 ausgebildet sind. Die Temperierfluidführungen 153 sind dazu ausgebildet, einen Temperierfluideinlass des Gehäuseelements mit dem Temperierfluidauslass des anderen Gehäuseelements fluidleitend zu verbinden, sodass eine parallel oder serielle Durchströmung ausgebildet sein kann.

Figur 8 zeigt in einer perspektivischen Ansicht eine Unterseite des ersten Gehäuseelements 2 gemäß Figur 7. Dabei ist insbesondere die erste Temperierstruktur 101 zu erkennen, welche auf einer dem Innenraum 5 abgewandten Seite des ersten Gehäuseelements angeordnet ist. Zudem sind der Temperierfluideinlass 163 der weiteren Temperierfluidaufnahme 111 und der Temperierfluidauslass 164 der weiteren Temperierfluidaufnahme 111 gezeigt. Die erste Temperierstruktur 101 ist hierbei als Strömungsleitelemente 121, als Strömungsstörelemente 122 oder als Strömungsbegrenzungen 123 ausgebildet. An dieser Stelle sei angemerkt, dass ein weiteres Abdeckelement 14, welches in der Figur 8 nicht zu erkennen ist, in der Art mit dem ersten Gehäuseelement 2 verbunden ist, dass das weitere Abdeckelement 14 die weitere Temperierfluidaufnahme einer der fluiddicht gegenüber einer Umgebung begrenzt.

## Patentansprüche

1. Batterie umfassend
ein erstes Gehäuseelement (2) und ein zweites Gehäuseelement (3), welche gemeinsam einen Innenraum (5) zur Aufnahme eines Batteriemoduls (10) ausbilden, wobei
in dem Innenraum (5) eine Mehrzahl an elektrisch leitend seriell und/oder parallel miteinander verschalteten Batteriezellen (6) des Batteriemoduls (10) angeordnet ist, wobei
die Batteriezellen (6) insbesondere prismatisch ausgebildet sind und
in dem Innenraum (5) weiterhin ein erstes Element (8) einer Batteriesteuerung angeordnet ist, wobei
das erste Element (8) der Batteriesteuerung zumindest ein elektronisches Bauteil (81) umfasst, welches
ein Schalter, ein Sicherungselement, ein Batteriesteuerungssystem und/oder ein Widerstand ist, wobei
das erste Gehäuseelement (2) auf einer dem Innenraum (5) und insbesondere dem zweiten Gehäuseelement (3) abgewandten Seite eine erste Temperierstruktur (101) ausbildet, wobei
das zweite Gehäuseelement (3) auf einer dem Innenraum (5) und insbesondere dem ersten Gehäuseelement (2) zugewandten Seite eine zweite Temperierstruktur (102) ausbildet, und
ein Abdeckelement (100) in der Art mit dem zweiten Gehäuseelement (3) verbunden ist, dass
das Abdeckelement (100) eine von Temperierfluid durchströmbare Temperierfluidaufnahme (112) fluidicht gegenüber dem Innenraum (5) begrenzt und die zweite Temperierstruktur (102) von dem Temperierfluid umströmbar ausgebildet ist, wobei
das erste Element (8) der Batteriesteuerung thermisch leitend an einer dem Innenraum (5) zugewandten Seite des Abdeckelements (100) angeordnet ist.

2. Batterie nach einem der vorherigen Ansprüche,
**dadurch gekennzeichnet, dass**
ein zweites Element (9) der Batteriesteuerung thermisch leitend an einer dem Innenraum (5) und insbesondere dem ersten Gehäuseelement (2) abgewandten Seite des zweiten Gehäuseelements (3) angeordnet ist.

3. Batterie nach einem der vorherigen Ansprüche,
**dadurch gekennzeichnet, dass**
das erste Element (8) der Batteriesteuerung weiterhin zumindest ein elektrisches Bauteil (80) umfasst.

4. Batterie nach dem vorherigen Anspruch 3,
**dadurch gekennzeichnet, dass**
das elektrische Bauteil (80) des Batteriemoduls (10) ein Zellverbinder (82) und/oder eine Leitung (83) ist.

5. Batterie nach einem der vorherigen Ansprüche,
**dadurch gekennzeichnet, dass**
das zumindest eine elektronische Bauteil (81) in eine Leiterplatte (90) integriert ist.

6. Batterie nach einem der vorherigen Ansprüche 2 bis 5,
**dadurch gekennzeichnet, dass**
das zweite Element (9) der Batteriesteuerung ein elektrischer Spannungswandler (91), insbesondere ein Gleichspannungswandler (92), ist.

7. Batterie nach einem der vorherigen Ansprüche,
**dadurch gekennzeichnet, dass**
das Abdeckelement (100) planar aus einem Metall ausgebildet ist oder dass das Abdeckelement (100) eine Umformung (110) zur Aufnahme des ersten Elements (8) der Batteriesteuerung aufweist.

8. Batterie nach einem der vorherigen Ansprüche,
**dadurch gekennzeichnet, dass**
die Mehrzahl an Batteriezellen (6) thermisch leitend mit einer unmittelbar benachbart zu der ersten Temperierstruktur (101) angeordneten ersten Innenseite des Innenraums (5) angeordnet ist.

9. Batterie nach einem der vorherigen Ansprüche,
**dadurch gekennzeichnet, dass**
das erste Gehäuseelement (2) und/oder das zweite Gehäuseelement (3) jeweils als Druckgussgehäuse (20, 30) ausgebildet sind.

10. Batterie nach einem der vorherigen Ansprüche,
**dadurch gekennzeichnet, dass**
das erste Gehäuseelement (2) und das zweite Gehäuseelement (3) fluiddicht ausgebildet miteinander verbunden sind, wobei insbesondere ein Dichtungselement (131) zwischen dem ersten Gehäuseelement (2) und dem zweiten Gehäuseelement (3) angeordnet ist.

11. Batterie nach einem der vorherigen Ansprüche,
**dadurch gekennzeichnet, dass**
ein weiteres Abdeckelement (14) in der Art mit dem ersten Gehäuseelement (2) verbunden ist, dass
das weitere Abdeckelement (14) eine von Temperierfluid durchströmbare weitere Temperierfluidaufnahme (111) fluidicht gegenüber einer Umgebung begrenzt und die erste Temperierstruktur (101) von dem Temperierfluid umströmbar ausgebildet ist.

12. Batterie nach einem der vorherigen Ansprüche,
**dadurch gekennzeichnet, dass**
die Batterie einen ersten Anschluss (151) ausgebildet der Batterie Temperierfluid zuzuführen und einen zweiten Anschluss (152) ausgebildet der Batterie (1) Temperfluid abzuführen, wobei
die Batterie in der Art ausgebildete Temperfluidführungen (153) aufweist, dass Temperierfluid die Temperierfluidaufnahme (112) und die weitere Temperierfluidaufnahme (111) seriell oder parallel durchströmen kann.

13. Batterie nach einem der vorherigen Ansprüche,
**dadurch gekennzeichnet, dass**
die erste Temperierstruktur (101) und/oder die zweite Temperierstruktur (102) jeweils als Strömungsleitelemente (121), als Strömungsstörelemente (122) oder als Strömungsbegrenzungen (123) ausgebildet.

14. Verwendung einer Batterie (1) nach einem der Ansprüche 1 bis 13 zur Temperierung und insbesondere zur Kühlung der Mehrzahl an Batteriezellen (6), des ersten elektrischen Bauteils (8), wobei ein als Temperierflüssigkeit oder als Temperiergas ausgebildetes Temperierfluid die erste Temperierstruktur (101) umströmt und wobei das als Temperierflüssigkeit ausgebildete Temperierfluid die Temperierfluidaufnahme (112) durchströmt.

## Claims

1. Battery comprising
a first housing element (2) and a second housing element (3), which together form an interior space (5) for receiving a battery module (10), wherein
a plurality of battery cells (6) of the battery module (10), which are connected in an electrically conducting manner to one another in series and/or in parallel, are arranged in the interior space (5), wherein
the battery cells (6) are in particular prismatic and
a first element (8) of a battery controller is further arranged in the interior space (5), wherein
the first element (8) of the battery controller comprises at least one electronic component (81), which
is a switch, a fuse element, a battery control system and/or a resistor, wherein
the first housing element (2) forms a first temperature-control structure (101) on a side facing away from the interior space (5) and in particular the second housing element (3), wherein
the second housing element (3) forms a second temperature-control structure (102) on a side facing the interior space (5) and in particular the first housing element (2), and
a covering element (100) is connected to the second housing element (3) in such a way that
the covering element (100) delimits a temperature-control fluid receptacle (112), through which a temperature-control fluid can flow, in a fluid-tight manner from the interior space (5) and the second temperature-control structure (102) is formed such that the temperature-control fluid can flow around it, wherein the first element (8) of the battery controller is arranged in a thermally conducting manner on a side of the covering element (100) that is facing towards the interior space (5).

2. Battery according to one of the preceding claims,
**characterized in that**
a second element (9) of the battery controller is arranged in a thermally conducting manner on a side of the second housing element (3) that is facing away from the interior space (5) and in particular the first housing element (2).

3. Battery according to either of the preceding claims,
**characterized in that**
the first element (8) of the battery controller further comprises at least one electrical component (80).

4. Battery according to preceding Claim 3,
**characterized in that**
the electrical component (80) of the battery module (10) is a cell connector (82) and/or a line (83).

5. Battery according to one of the preceding claims,
**characterized in that**
the at least one electronic component (81) is integrated in a printed circuit board (90).

6. Battery according to one of preceding Claims 2 to 5,
**characterized in that**
the second element (9) of the battery controller is an electrical voltage converter (91), in particular a DC-DC voltage converter (92).

7. Battery according to one of the preceding claims,
**characterized in that**
the covering element (100) is formed from a metal in a planar manner, or **in that**
the covering element (100) has a shaped portion (110) for receiving the first element (8) of the battery controller.

8. Battery according to one of the preceding claims,
**characterized in that**
the plurality of battery cells (6) is arranged in thermally conducting contact with a first inner side of the interior space (5) that is arranged directly adjacent to the first temperature-control structure (101).

9. Battery according to one of the preceding claims,
**characterized in that**
the first housing element (2) and/or the second housing element (3) are each formed as diecast housings (20, 30).

10. Battery according to one of the preceding claims,
**characterized in that**
the first housing element (2) and the second housing element (3) are connected to one another in a fluid-tight form, wherein in particular
a sealing element (131) is arranged between the first housing element (2) and the second housing element (3).

11. Battery according to one of the preceding claims,
**characterized in that**
a further covering element (14) is connected to the first housing element (2) in such a way that
the further covering element (14) delimits a further temperature-control fluid receptacle (111), through which a temperature-control fluid can flow, in a fluid-tight manner from a surrounding area and the first temperature-control structure (101) is formed such that the temperature-control fluid can flow around it.

12. Battery according to one of the preceding claims,
**characterized in that**
the battery a first connector (151) formed to feed temperature-control fluid to the battery and a second connector (152) formed to discharge temperature-control fluid from the battery (1), wherein
the battery has temperature-control fluid conduits (153) formed in such a way that temperature-control fluid can flow through the temperature-control fluid receptacle (112) and the further temperature-control fluid receptacle (111) in series or in parallel.

13. Battery according to one of the preceding claims,
**characterized in that**
the first temperature-control structure (101) and/or the second temperature-control structure (102) are each formed as flow-guiding elements (121), as flow-disrupting elements (122) or as flow-delimiting means (123).

14. Use of a battery (1) according to one of Claims 1 to 13 for temperature control and in particular for cooling the plurality of battery cells (6) and the first electrical component (8), wherein a temperature-control fluid formed as a temperature-control liquid or as a temperature-control gas flows around the first temperature-control structure (101) and wherein the temperature-control fluid formed as a temperature-control liquid flows through the temperature-control fluid receptacle (112).

## Revendications

1. Batterie, comprenant
un premier élément de boîtier (2) et un deuxième élément de boîtier (3), lesquels forment ensemble un espace intérieur (5) destiné à recevoir un module de batterie (10),
une pluralité d'éléments de batterie (6) du module de batterie (10), connectés en série et/ou en parallèle les uns aux autres de manière électriquement conductrice, étant disposés dans l'espace intérieur (5),
les éléments de batterie (6) étant notamment de forme prismatique et
un premier élément (8) d'une commande de batterie étant en outre disposé dans l'espace intérieur (5),
le premier élément (8) de la commande de batterie comportant au moins un composant électronique (81), lequel
est un commutateur, un élément de sécurité, un système de commande de batterie et/ou une résistance;
le premier élément de boîtier (2) formant une première structure d'équilibrage de température (101) sur un côté opposé à l'espace intérieur (5) et en particulier au deuxième élément de boîtier (3),
le deuxième élément de boîtier (3) formant une deuxième structure d'équilibrage de température (102) sur un côté opposé à l'espace intérieur (5) et en particulier au premier élément de boîtier (2), et
un élément de recouvrement (100) étant relié au deuxième élément de boîtier (3) de telle sorte que
l'élément de recouvrement (100) délimite, de manière étanche aux fluides par rapport à l'espace intérieur (5), un logement de fluide d'équilibrage de température (112) qui peut être traversé par un courant de fluide d'équilibrage de température et la deuxième structure d'équilibrage de température (102) est configurée de manière à pouvoir être contournée par le courant de fluide d'équilibrage de température,
le premier élément (8) de la commande de batterie étant disposé de manière thermiquement conductrice sur un côté de l'élément de recouvrement (100) qui fait face à l'espace intérieur (5).

2. Batterie selon l'une des revendications précédentes,
**caractérisée en ce que**
un deuxième élément (9) de la commande de batterie est disposé de manière thermiquement conductrice sur un côté du deuxième élément de boîtier (3) opposé à l'espace intérieur (5) et en particulier au premier élément de boîtier (2).

3. Batterie selon l'une des revendications précédentes,
**caractérisée en ce que**
le premier élément (8) de la commande de batterie comporte en outre au moins un composant électrique (80).

4. Batterie selon la revendication 3 précédente,
**caractérisée en ce que**
le composant électrique (80) du module de batterie (10) est un connecteur d'élément (82) et/ou une ligne (83).

5. Batterie selon l'une des revendications précédentes,
**caractérisée en ce que**
l'au moins un composant électronique (81) est intégré dans une carte à circuit imprimé (90).

6. Batterie selon l'une des revendications 2 à 5 précédentes,
**caractérisée en ce que**
le deuxième élément (9) de la commande de batterie est un convertisseur de tension électrique (91), notamment un convertisseur de tension continue (92).

7. Batterie selon l'une des revendications précédentes,
**caractérisée en ce que**
l'élément de recouvrement (100) est formé de manière plane en un métal ou **en ce que**
l'élément de recouvrement (100) présente une déformation (110) destinée à recevoir le premier élément (8) de la commande de batterie.

8. Batterie selon l'une des revendications précédentes,
**caractérisée en ce que**
la pluralité d'éléments de batterie (6) sont disposés de manière thermiquement conductrice avec un premier côté intérieur de l'espace intérieur (5) disposé immédiatement adjacent à la première structure d'équilibrage de température (101).

9. Batterie selon l'une des revendications précédentes,
**caractérisée en ce que**
le premier élément de boîtier (2) et/ou le deuxième élément de boîtier (3) sont respectivement réalisés sous forme de boîtier moulé sous pression (20, 30).

10. Batterie selon l'une des revendications précédentes,
**caractérisée en ce que**
le premier élément de boîtier (2) et le deuxième élément de boîtier (3) sont reliés l'un à l'autre de manière étanche aux fluides, en particulier
un élément d'étanchéité (131) étant disposé entre le premier élément de boîtier (2) et le deuxième élément de boîtier (3).

11. Batterie selon l'une des revendications précédentes,
**caractérisée en ce que**
un élément de recouvrement supplémentaire (14) est relié au premier élément de boîtier (2) de telle sorte que
l'élément de recouvrement supplémentaire (14) délimite, de manière étanche aux fluides par rapport à l'environnement, un logement de fluide d'équilibrage de température supplémentaire (111) qui peut être traversé par un courant de fluide d'équilibrage de température et la première structure d'équilibrage de température (101) est configurée de manière à pouvoir être contournée par le courant de fluide d'équilibrage de température.

12. Batterie selon l'une des revendications précédentes,
**caractérisée en ce que**
la batterie un premier raccord (151), configuré pour amener du fluide d'équilibrage de température à la batterie, et un deuxième raccord (152), configuré pour évacuer du fluide d'équilibrage de température de la batterie (1),
la batterie possédant des guides de fluide d'équilibrage de température (153) configurés de telle sorte que le fluide d'équilibrage de température peut traverser le logement de fluide d'équilibrage de température (112) ainsi que le logement de fluide d'équilibrage de température supplémentaire (111) en série ou en parallèle.

13. Batterie selon l'une des revendications précédentes,
**caractérisée en ce que**
la première structure d'équilibrage de température (101) et/ou la deuxième structure d'équilibrage de température (102) sont respectivement réalisées sous la forme d'éléments de guidage d'écoulement (121), d'éléments de perturbation d'écoulement (122) ou de limitations d'écoulement (123).

14. Utilisation d'une batterie (1) selon l'une des revendications 1 à 13 pour l'équilibrage de température et en particulier pour le refroidissement de la pluralité d'éléments de batterie (6), du premier composant électrique (8), un fluide d'équilibrage de température, réalisé sous la forme d'un liquide d'équilibrage de température ou comme un gaz d'équilibrage de température, s'écoulant autour de la première structure d'équilibrage de température (101) et le fluide d'équilibrage de température réalisé sous la forme d'un liquide d'équilibrage de température s'écoulant à travers le logement de fluide d'équilibrage de température (112).
